# EUROPÄISCHE PATENTANMELDUNG

(11) **EP 1 234 808 A1**
(43) Veröffentlichungstag der Anmeldung: **28.08.2002**
(21) Anmeldenummer: 01810187.3
(22) Anmeldetag: 22.02.2001
(51) Int. Cl.: C04B 41/45, C23C 16/40, G02B 1/10

(54) **Transparente, mineralische Körper mit Entspiegelungsschicht und Verfahren zu deren Herstellung**

(71) Anmelder: Blösch Holding AG, 2540 Grenchen (CH)
(72) Erfinder: Zimmermann, Heinrich, 9470 Werdenberg (CH)
(74) Vertreter: AMMANN PATENTANWAELTE AG BERN

(57) **Zusammenfassung**

Hochschmelzende, optisch transparente mineralische Körper können mittels CVD-Beschichtung mit einer Entspiegelungsschicht versehen werden, die eine sehr hohe optische Homogenität und/oder hohe Härte aufweist. In einer bevorzugten Ausführungsform ist es möglich, kugelförmige Substrate, z.B. aus Saphir, mit einer derartigen abriebfesten und zugleich qualitativ hochwertigen Spiegelungsschicht gleichzeitig in grosser Zahl zu versehen. Eine bevorzugte Anwendung solcher Saphirkugeln findet sich wegen ihrer hohen Brechkraft und der mit der Schicht stark verringerten Reflexionsverluste in der Telekummunikation mittels Licht. Hochkratzfeste Schichten hoher optischer Qualität, d.h. optischer Homogenität, werden jedoch auch für Uhrgläser benötigt.

## Beschreibung

Die vorliegende Erfindung bezieht sich auf ein Verfahren zur Herstellung einer Entspiegelungsschicht gemäss Oberbegriff des Anspruchs 1. Die Erfindung bezieht sich weiterhin auf mit dem Verfahren beschichtete Körper.

Entspiegelungsschichten (auch Antireflexschichten genannt) sind bekannt und werden weltweit industriell vornehmlich auf Brillengläsern aus Mineralglas oder aus Kunststoffglas und für die Feinoptik auf Linsen jeder Art und Anwendung hergestellt. Solche Entspiegelungen basieren auf Einfachoder Mehrfachschichten und setzen sich aus Kombinationen hoch- und niedrigbrechender Materialien, wie TiO₂, SiO₂, HfO₂, MgF₂ usw. zusammen, welche heute vorzugsweise mittels Aufdampfen, aber auch mittels Aufstäuben (sog. *Sputtern*) aufgebracht werden. Die genannten dielektrischen Materialien zeichnen sich durch ideale Brechwerte aus, wenn sie auf Substrate aufgebracht werden, die ihrerseits Brechwerte n zwischen 1,5 und 2,1 aufweisen. Der einzige Nachteil der aufgedampften Schichten liegt in ihrer relativ geringen Härte, was sich durch schnellen Abrieb und Verkratzen der Oberfläche unangenehm bemerkbar macht, wenn die beschichteten Oberflächen in mechanische Wechselwirkung mit der Umgebung treten (Brillenträger kennen das Problem).

In der Uhrenindustrie werden Entspiegelungsschichten seit den 80-iger Jahren eingesetzt, jedoch zu Beginn ausschliesslich auf Mineralgläsern für professionelle Armbanduhren vom Typ Chronometer. Mit der Einführung von weitgehend kratzfesten Uhrengläsern aus Saphirglas (monokristallines Aluminiumoxid) nimmt die Bedeutung der Entspiegelung zu, weil diese Gläser unbeschichtet insgesamt 6,5 % mehr spiegeln als Mineralgläser. Beim Saphirglas mit seiner hohen optischen Dichte (Brechwert) von 1,77 sind es 7,7 % je Seite, also 15,4 % insgesamt. Die Lesbarkeit des Zifferblattes wird demzufolge um einen Faktor 2 verschlechtert, was vom Markt bemerkt und zunehmend bemängelt wird.

Ein Verfahren zum Anbringen einer Entspiegelungsschicht auf einem Saphirglas ist z.B. aus der europäischen Patentanmeldung Nr. 00810345, angemeldet am 19. April 2000, der Anmelderin bekannt. Darin wird ausgeführt, dass sich durch Sputtern unter besonderen Bedingungen eine hochkratzfeste Entspiegelungsschicht erzeugen lässt, die insbesondere die Verkratzungsfestigkeit von Saphirglas nicht beeinträchtigt, d.h. vergleichbare Verkratzfestigkeit aufweist. Da der normierte Bayer-Test (ASTM F735-94) bereits bei diesen Schichten keine auswertbaren Abrieb- und Verkratzungseffekte mehr zeigt, wurde der "verschärfte Bayer-Test" entwickelt. Der Standard-Bayer-Test besteht im Wesentlichen daraus, dass die Testsubstrate in eine Blechwanne gegeben und mit einer bestimmten Menge Quarzsand bedeckt werden. Die Wanne wird mit Hilfe einer Schüttelvorrichtung 100 bis 600 Zyklen Schüttelbewegungen ("strokes") mit einer vorgegebenen Frequenz und Amplitude unterworfen. Die Zunahme des Streulichts gegenüber dem unbeschichteten Substrat ergibt ein Mass für die Kratzbeständigkeit.

Der verschärfte Bayer-Test zeichnet sich gegenüber dem normierten Bayer-Test (ASTM F735-94) durch folgende Abwandlung aus:
- Korund-Sand (Normalkorund SAN F046) statt Quarz-Sand,
- 13500 "strokes" statt 600,
- 60 mm Hub statt 50 mm, und
- Höhe der Sandschicht 25 mm statt 13 mm.
- Frequenz 450 min⁻¹ statt 300 min⁻¹.

Eine Aufgabe der vorliegenden Erfindung besteht darin, ein Verfahren anzugeben, mit dem Entspiegelungsschichten weiter erhöhter Kratz- und/oder Abriebfestigkeit auf optisch transparenten mineralischen Substraten hoher Härte hergestellt werden können.

Solch ein Verfahren ist im Anspruch 1 angegeben. Die weiteren Ansprüche geben bevorzugte Ausführungsformen und mit dem Verfahren beschichtete Körper an.

CVD-Verfahren, die eine Alternative zu den PVD-Beschichtungsverfahren darstellen, jedoch in der Regel höhere Kosten verursachen, sind dafür bekannt, auch auf komplex geformten Oberflächen gleichmässige Schichten zu ergeben. Die gleichmässigen Schichten rühren im Wesentlichen daher, dass die Abscheidung ohne den Einfluss von elektrischen und magnetischen Feldern erfolgt, die beim PVD-Verfahren benötigt werden. Die beim CVD-Verfahren auftretenden hohen Temperaturen schränken jedoch die Anwendbarkeit auf Substrate entsprechend hoher Temperaturfestigkeit ein. In der Regel besteht dennoch die Gefahr eines Verschweissens, wenn eine grössere Anzahl Substrate gleichzeitig beschichtet werden sollen, wie es in der Regel geschieht, und dazu auf einem Träger angeordnet werden: Es ist daher nötig, sie an festen Positionen eine gewisse Zeit lang ohne Bewegung und ohne gegenseitige Berührung zu beschichten. Während dieser Zeit erfolgt jedoch eine ungleichmässige Beschichtung, insbesondere wird die Schicht zum Auflagepunkt hin zunehmend dünner, und am Auflagepunkt selber wird notwendigerweise überhaupt keine Beschichtung erfolgen.

Ist eine Schicht minimaler Dicke abgeschieden, können die Substrate in eine unkontrollierte Bewegung versetzt werden, da die Schicht ein Verschweissen verhindert. Die schon bestehenden Defekte nahe der Auflagestelle werden durch den weiteren Beschichtungsprozess zwar gemildert, lassen aber die Verwendung der Körper in Anwendungen, die eine hohe optische Qualität erfordern, nicht mehr oder allenfalls nach Nachbearbeitung zu. Eine solche Anwendung sind z.B. Linsensysteme in Telekommunikationseinrichtungen, in denen Licht zur Übertragung verwendet wird. Gerade in diesen Anwendungen sind kleine Linsen hoher Beugung erforderlich, so dass als Extremfall Kugeln für die Linsensysteme mit geringem Lichtverlust durch Reflexion gefordert werden. Die erforderlichen, die ganze Oberfläche bedeckenden Entspiegelungsschichten konstanter Dicke konnten jedoch bisher aus oben genannten Gründen nicht in der Serienfertigung hergestellt werden. Auch bei Nacharbeitung verblieben Abweichungen, die jedenfalls einen Einsatz von beschichteten Kugeln ohne Beachtung der Orientierung nicht erlaubten. Eine Einzelfertigung verbietet sich aus Kostengründen.

Eine andere Aufgabe der vorliegenden Erfindung besteht daher darin, ein Verfahren anzugeben, mit dem als optische Linsen verwendbare Körper mit geringerem Aufwand mit einer Entspiegelungsschicht gleichmässiger Dicke ausgestattet werden können, die die gesamte Oberfläche bedeckt.

Ein solches Verfahren ist im Anspruch 2 angegeben.

Für die vorgenannten optischen Systeme im Bereich der Telekommunikation mittels Lichtstrahlen (Laser) wären Stoffe hoher Brechkraft wie z.B. Saphir (Brechungsindex 1,77) eigentlich vorteilhaft. Insbesondere Saphir weist jedoch auch einen hohen Reflexionsgrad von etwa 7,7 % auf, was zu einem Lichtverlust von 15,4 % insgesamt für Ein - und Austritt des Lichtes führt. Es wurde nun überraschend gefunden, dass es möglich ist, Saphir-Kugeln mit einer Entspiegelungs- oder Antireflexschicht zu versehen, die die ganze Oberfläche mit konstanter Dicke überzieht. Der wesentliche Punkt dabei ist die Erkenntnis, dass Saphir auch unter den hohen Temperaturen des CVD-Verfahrens keine Neigung zum Verschweissen zeigt. Die unbeschichteten Saphirlinsen (Kugeln) können daher von Anfang an während des Beschichtens in grosser Zahl auf einen gemeinsamen Träger in eine unkontrollierte Rollbewegung versetzt werden, wodurch der oben geschilderte Nachteil des CVD-Verfahrens nicht auftritt. Vielmehr wird eine Schicht erhalten, die eine sehr hohe optische Homogenität unabhängig von der Orientierung aufweist. Die Messungen der optischen Homogenität lassen den Schluss zu, dass die Schichtdickenabweichungen jedenfalls unter 1 % liegen.

Mit den so erhaltenen Entspiegelungsschichten werden Reflexionsverluste von ca. 0,6 % pro Phasengrenze erreicht, also insgesamt für Ein- und Austritt aus der Linse von ca. 1 %.

Grundsätzlich ist es möglich, diese Entspiegelungsschichten aus allen bekannten und im CVD-Verfahren herstellbaren Schichten aufzubauen. Bevorzugt wird jedoch wenigstens als oberste Schicht Siliziumdioxid, da es zugleich die Linsen gegen Verkratzen schützt, wie noch beschrieben wird.

Überraschend wurde weiter gefunden, dass die Schichten, die mit dem CVD-Verfahren abgeschieden wurden, auch hinsichtlich der Kratz- und Abriebfestigkeit den bekannten Schichten überlegen sind, auch denjenigen der eingangs genannten Patentanmeldung der Anmelderin. Es kann vermutet werden, dass dies wenigstens z.T. darauf beruht, dass sich beim CVD-Verfahren Kristallstrukturen ausbilden, während beim PVD-Verfahren die Schicht eher eine amorphe Struktur aufweist. Es wurde jedenfalls gefunden, dass eine Entspiegelungsbeschichtung mit einer obersten Schicht aus Siliziumdioxid, das mittels CVD-Verfahren aufgebracht wurde, im verschärften Bayer-Test einen Abrieb von höchstens 2 nm aufweist. Eine durch Sputtern aufgebrachte Schicht weist dagegen einen Abrieb von 15 nm auf. Ein Verkratzen der Schicht konnte nicht mehr festgestellt werden.

Verfahren für die CVD-Beschichtung wie auch die dafür nötigen Reaktanden sind an sich bekannt. Eine Auswahl von Materialien und der jeweils nötigen Temperatur für die Abscheidung findet sich in der folgenden Tabelle:

**Tabelle 1:**

| Auswahl von CVD-Reaktionen | | |
|---|---|---|
| Schicht | Reaktionstemperatur [°C] | Reaktanden |
| TiC | 1000 | CH₄, H₂, TiCl₄ (30 °C) |
| VC | 1050 | CH₄, H₂, VCl₂ (1050 °C) |
| SiC | 800 | CH₄, H₂, SiH₄(g) |
| W₂C | 600 | C₆H₆, H₂, WF₆ (30 °C) |
| TiN | 950 | N₂, H₂, TiCl₄ (30 °C) |
| Si₃N₄ | 1200 | NH₃, H₂, SiCl₄(g) |
| SiO₂ | 500 | SiH₄, N₂O(g) |
| Si₃N₄ | 780 | NH₃, SiH₂Cl₂ (g) |
| Al₂O₃ | 1000 | CO₂, H₂, AlCl₃ (150 °C) |
| Si | 1100 | H₂, SiHCl₃ (g) |
| W | 900 | H₂, WF₆ (30 °C) |
| C | 1400 | C₂H₆ oder C₃H₈ |

Eine beispielhafte Durchführung einer Beschichtung gestaltet sich wie folgt:

In einem CVD-Reaktor werden die Substrate (Saphir-Kugeln) auf einer drehbaren Unterlage plaziert. Im Reaktor wird ein Vakuum mit einem Druck von 0,1 mBar hergestellt. Durch mehrmaliges Spülen mit Stickstoff wird der Reaktor von Restsauerstoff befreit und anschliessend auf die Reaktionstemperatur von 720 °C aufgeheizt. Über ein Gasdosierventil wird ein Gasfluss von 50 ml/min (unter Standardbedingungen: 25 °C/1 Bar) Tetraethoxysilan, welches durch Aufheizen auf 100 °C verdampfbar wird, eingestellt und zusätzlich 1000 ml/min (unter Standardbedingungen) Stickstoff eingelassen. Die Substrate werden nun durch Drehen der Substratunterlage in Bewegung gehalten, so dass die ganze Oberfläche homogen beschichtet wird. Nach 24 Minuten war die Oberfläche mit einer 147,5 nm dicken Schicht aus Siliziumdioxid beschichtet. Die Restreflexion bei 850 nm auf Saphir-Substraten beträgt noch 0,9 %.

Mögliche Schichtenfolgen für Antireflexbeschichtungen sind an sich bekannt, z.B. aus der eingangs genannten Patentanmeldung, die insbesondere für Uhrengläser bestimmt sind, wie Si₃N₄/SiO₂; ZrN/ZrO₂ (mit Farbeffekt); AlN/SiO₂; AlN/Al₂O₃/Si₃N₄/SiO₂ und andere, auch unter Wiederholung. Zusätzlich kann noch eine dünne Schutzschicht als oberste Schicht vorhanden sein, z.B. aus Si₃N₄, ZrN, Al₂O₃, oder ZrO₂. Eine beispielhafte Schichtenfolge ist: Substrat; Si₃N₄: 20nm; SiO₂: 20nm; Si₃N₄: 90nm; SiO₂: 120nm (Schichtdicken jeweils als optische Dicke angegeben).

Aus der vorgenannten Beschreibung sind dem Fachmann zahlreiche Varianten zugänglich, ohne den Bereich der Erfindung zu verlassen. Insbesondere sind als Substrate hoher Härte neben Saphir auch Quarz und Ziakoniumdioxid denkbar. Hinsichtlich der Form der Substrate zur Verwendung als Linsen sind insbesondere neben Kugeln auch Ellipsoide und linsenförmige Gestalt denkbar.

## Patentansprüche

1. Verfahren zur Erzeugung einer Entspiegelungsschicht auf einem hochschmelzenden optisch transparenten mineralischen Substrat mit einer Mohs-Härte von mindestens 7, **dadurch gekennzeichnet, dass** die Entspiegelungsschicht mittels eines CVD-Verfahrens auf dem Substrat abgeschieden wird, um eine abriebbeständige und kratzfeste Schicht zu erhalten.

2. Verfahren zur Erzeugung einer optisch homogenen Entspiegelungsschicht auf hochschmelzenden, optisch transparenten mineralischen Substraten, **dadurch gekennzeichnet, dass** die Entspiegelungsschicht mittels eines CVD-Verfahrens auf dem Substrat abgeschieden wird, wobei das Substrat während im Wesentlichen der gesamten Dauer des Beschichtungsverfahrens durch Bewegen der Unterlage, auf dem das Substrat liegt, in Bewegung gehalten wird, um die Behinderung der Schichtbildung an der Auflagefläche zu unterdrücken.

3. Verfahren gemäss Anspruch 2, **dadurch gekennzeichnet, dass** eine Vielzahl, bevorzugt mindestens 10 und insbesondere bevorzugt mindestens 100 Substrate, insbesondere kugelförmige ellipsoide oder linsenförmige Substrate, zugleich beschichtet werden.

4. Verfahren gemäss Anspruch 1 und einem der Ansprüche 2 oder 3.

5. Verfahren gemäss einem der Ansprüche 1 bis 4, **dadurch gekennzeichnet, dass** wenigstens als oberste Schicht der Entspiegelungsschicht Siliziumdioxid auf dem Substrat abgeschieden wird.

6. Verfahren gemäss einem der Ansprüche 1 bis 5, **dadurch gekennzeichnet, dass** das Substrat im Wesentlichen aus Quarz, Saphir oder Zirkoniumdioxid besteht.

7. Körper aus hochschmelzendem, optisch transparentem mineralischem Material mit einer Entspiegelungsschicht, die mit dem Verfahren gemäss einem der Ansprüche 1 bis 6 herstellbar ist.

8. Körper gemäss Anspruch 7, **dadurch gekennzeichnet, dass** der Körper linsenförmige, ellipsoide oder kugelförmige Gestalt aufweist und im Wesentlichen an der ganzen Oberfläche mit einer optisch homogenen Entspiegelungsschicht versehen ist.

9. Körper gemäss einem der Ansprüche 7 bis 8, **dadurch gekennzeichnet, dass** das Substrat eine Mohs-Härte von mindestens 7 aufweist, bevorzugt aus Quarz, Zirkoniumdioxid oder Saphir besteht.

10. Körper gemäss einem der Ansprüche 7 bis 9, **dadurch gekennzeichnet, dass** die Entspiegelungsschicht wenigstens an der Oberfläche aus Siliziumdioxid besteht, um eine hohe Abrieb- und Kratzfestigkeit zu gewährleisten.

11. Körper gemäss einem der Ansprüche 7 bis 10, **dadurch gekennzeichnet, dass** die Entspiegelungsschicht im "verschärften Bayer-Test" einen Abrieb von höchstens 2 nm zeigt.
